Europäisches Patentamt

European Patent Office

Office européen des brevets

(11) Publication number: **0 430 476 A1**

# EUROPEAN PATENT APPLICATION

(21) Application number: 90312277.8

(22) Date of filing: 09.11.90

(51) Int. Cl.⁵: **H01L 21/312**, H01L 23/498

(30) Priority: 20.11.89 US 440837

(43) Date of publication of application:
05.06.91 Bulletin 91/23

(84) Designated Contracting States:
DE FR GB IT Bulletin

(71) Applicant: AMERICAN TELEPHONE AND
TELEGRAPH COMPANY
550 Madison Avenue
New York, NY 10022(US)

(72) Inventor: Wong, Ching Ping
11 Wexford Drive
Lawrenceville, New Jersey 08548(US)

(74) Representative: Johnston, Kenneth Graham et
al
AT&T (UK) LTD. AT&T Intellectual Property
Division 5 Mornington Road
Woodford Green Essex, IG8 OTU(GB)

(54) Improved silicone-polyimide material for electronic devices.

(57) A dielectric layer for use in an electronic device comprises a silicone-polyimide co-polymer, which, prior to cure, has been mixed with a silane coupling agent selected from the group consisting of N-(2-aminoethyl-3-aminopropyl) trimethoxysilane and 3-mercaptopropyltrimethoxysilane.

EP 0 430 476 A1

## IMPROVED SILICONE-POLYIMIDE MATERIAL

### Technical Field

This invention relates to dielectric materials used in conjunction with electronic devices, and, more particularly, to silicone-polyimide dielectric layers.

### Background of the Invention

As described, for example, in the paper "Integrated Circuit Device Encapsulants," by C. P. Wong, included in the book *Polymers for Electronic Applications*, edited by J. H. Lai, CRC Press, Inc., Boca Raton, Florida, 1989, pp. 63-92, organic materials such as silicones and polyimides are coming into increased use for electronics packaging, encapsulation and interconnection. Many of these materials have the appropriate thermal stability, dielectric properties, chemical stability and resistance to atmospheric deterioration needed for use either as dielectric layers or as encapsulants. Such materials are particularly useful as dielectric layers and encapsulants for hybrid integrated circuits (HICs) in which a silicon chip is mounted on a ceramic substrate having a metal conductive pattern on one surface.

A particularly good dielectric layer for use with high voltage HICs is a silicone-polyimide co-polymer which will be described more completely later. This material resists applied high voltages without breakdown, and therefore is useful as a dielectric layer between a high-voltage silicon chip and a ceramic substrate upon which metal conductors have been defined. Unfortunately, this material has exhibited a tendency to delaminate, particularly from gold conductors on the ceramic surface substrate, after an extended period of use.

### Summary of the Invention

In accordance with the invention, a dielectric layer for use in an electronic device comprises a silicone-polyimide co-polymer, which, prior to cure, has been mixed with a silane coupling agent selected from the group consisting of N-(2-aminoethyl-3-aminopropyl) trimethoxysilane and 3-mercaptopropyltrimethoxysilane. Silicone-polyimide by itself is known to be particularly good as a dielectric, which is able to withstand high voltages, such as voltages on the order of 600 volts. With the silane coupling agent, I have found that this material dependably adheres to silicon, ceramic and gold metal conductors and can thereby be expected to have extremely long life as a dielectric layer when used in a hybrid integrated circuit for separating a high-voltage silicon chip from the metal conductors of a ceramic substrate. As will be described later, such apparatus has been subjected to rigorous testing, which invariably induces delamination of silicone-polyimide co-polymers that do not utilize the invention; such testing shows dependable adherence of such co-polymers that do employ the invention.

These and other objects, features and benefits of the invention will be better understood from a consideration of the detailed description taken in conjunction with the accompanying drawing.

### Brief Description of the Drawing

FIG. 1 is a schematic sectional view of a portion of a hybrid integrated circuit employing a dielectric layer made in accordance with an illustrative embodiment of the invention;

FIG. 2 is an illustration of chemical reactions used to make silicone-polyimide co-polymers with which the invention can be used.

### Detailed Description

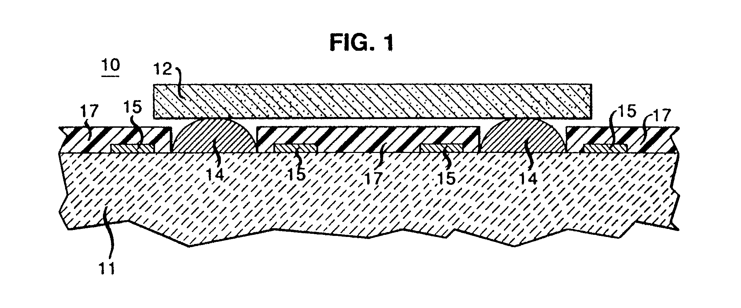

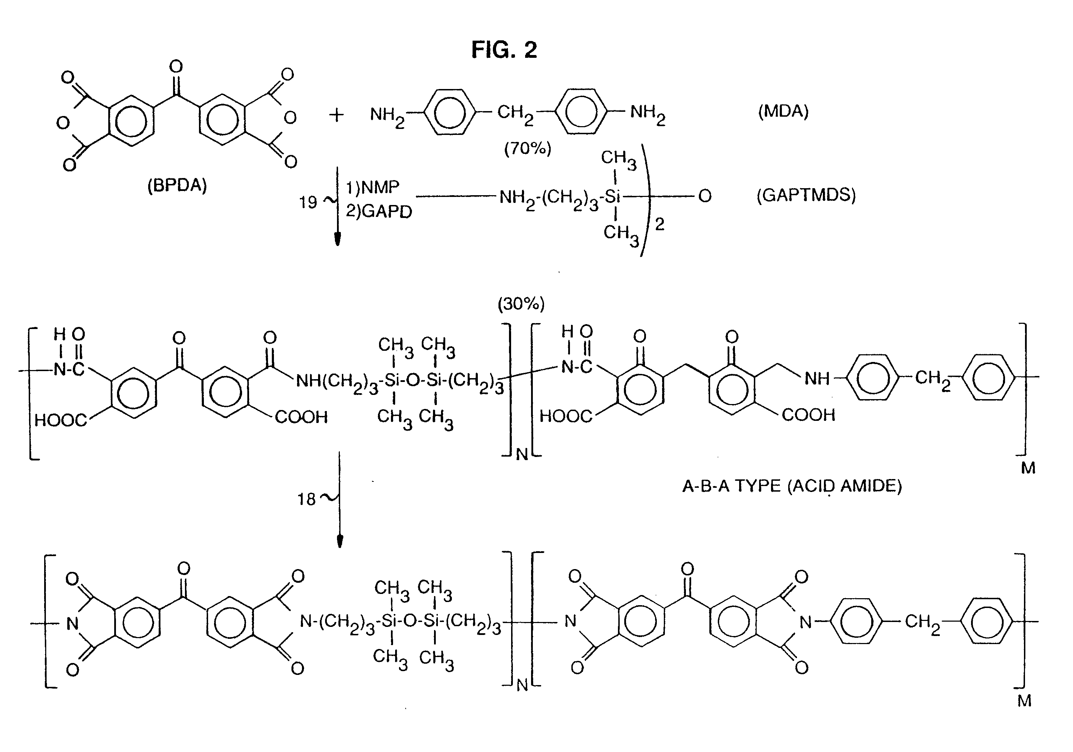

Referring now to FIG. 1, there is shown schematically a hybrid integrated circuit 10 comprising a ceramic substrate 11 upon which is mounted a silicon chip 12. It is to be understood that the figure is not to scale, and in fact is grossly distorted with respect to actual dimensions for the purpose of illustrating the structure and function of relevant components. The silicon chip 12 has defined within it a number of high-voltage electronic devices, as, for example, devices known in the art as gated diode crosspoint switches (GDXs) which may typically develop voltages in excess of 600 volts. The silicon chip is mounted on the ceramic substrate by solder members 14 which may be solder leads and/or elements referred to in the art as "solder bumps." An electronic circuit is defined on the upper surface of the ceramic substrate 11 by a plurality of metal conductors 15 which may typically be gold, or have an outer coating of gold. It is known in the art to insulate the conductors 15 from the silicon chip 12 by a dielectric layer 17 of a silicone-polyimide co-polymer. Referring to FIG. 2, a silicone-polyimide co-polymer of the prior art has as its chemical formula that chemical formula shown below arrow 18.

The dielectric layer 17 is typically deposited on the surface of the ceramic substrate 11 by screen printing prior to the bonding of the silicon chip 12 to solder bumps 14. The dielectric layer may be of the thickness sufficient to contact the lower surface of the chip 12, or it may be somewhat thinner so as to leave a small gap as illustrated in the drawing. In accordance with the invention, prior to deposit, the silicone-polyimide co-polymer is mixed with a silane coupling agent selected selected from the group consisting of N-(2-aminoethyl-3-aminopropyl) trimethoxysilane and 3-mercaptopropyltrimethoxysilane such that the coupling agent constitutes 0.2 to 1.6 percent by weight of the composite material. Specifically, four successful mixtures were made containing, respectively, 0.2, 0.4, 0.8 and 1.6 percent by weight of the silane coupling agent. Each of these were tested for adhesion on a ceramic substrate having gold conductors by boiling for one hour in Freon TMC (a mixture of a methylene chloride solvent with a chlorofluorocarbon known by the trademark Freon TF) which is commercially available from the Du Point Company of Wilmington, Delaware. All of the samples showed no delamination or significantly less delamination than comparative samples of silicone-polyimide co-polymers without the silane coupling agent. The samples containing 0.8 and 1.6 percent were marginally better than those containing 0.2 and 0.4 percent by weight. It is likely that greater amounts of the silane coupling agent could be used if so desired, but there appears to be no advantage in using more than 1.6 percent by weight, and it is unlikely that one would be motivated to do so, since the silane coupling agent is significantly more expensive than silicone-polyimide co-polymer. Moreover, too much silane coupling agent would reduce the dielectric reliability of the co-polymer. Thus, in principle, one should use at least 0.2 percent by weight of the silane coupling agent for significantly improved results; one should use 0.8 percent by weight or more for maximum improvement; and for improvement consistent with good economic practice should use a silane coupling agent in the range of 0.2 to 1.6 percent by weight.

Both of the silane coupling agents that were tried have a methoxy frunctional group which is believed to react with the siloxane segment of the silicone-polyimide co-polymer. One of the agents has an amino functional group and the other has a mercapto functional group, each of which is believed to provide adhesion to the gold-plated substrate. As a consequence, one obtains an intimate and continuous bond between the co-polymer and the gold-plated substrate.

The silicone-polyimide co-polymer that was used in all of the tests is known as M&T Rely-Imide-600, commercially available from M&T Chemicals of Rahway, New Jersey. FIG. 2 is a typical example of reactions used in producing silicone-polyimide co-polymer. Referring to the upper portion of FIG. 2, the starting materials are 3,3´,4,4´-biphenyltetracarboxylic dianhydride or benzophenone dianhydride, which is the formulation to the left of the plus sign, designated BPDA, and methylene dianiline, which is the formula to the right of the plus sign, designated MDA. Seventy percent of these starting materials are mixed with thirty percent of bis-gamma-aminopropyltetramethydisiloxane, designated GAPD, mixed in a solvent of N-methylpyrrolidinone, designated NMP. Arrow 19 shows a reaction to form an A-B-A type (acid amide). This is cured at a temperature of 100°C for one hour, then 200° for two hours, which is designated by arrow 18, which leads to the silicone-polymer co-polymer shown below arrow 18. Cure time varies inversely with cure temperature; for example, the final cure may be at 200°C for two to three hours or at 150°C for about four hours. Curing first at 100°C is recommended but not essential.

In accordance with the invention, of course, the silane coupling agent is mixed into the A-B-A type precursor prior to curing. The proportion of silane coupling agent needed to be effective is sufficiently small as not to affect the viscosity, and thus the screen printability prior to curing, nor does it affect the mechanical or other characteristics after cure other than its adhesion.

The particular dielectric layer embodiment of the invention is intended to be merely illustrative of the invention, as would be clear to one skilled in the art, and the good adhesion and good dielectric characteristics of the material disclosed would make it a likely candidate for use as an electronic device encapsulant. Various other embodiments and modifications of the invention would be clear to one skilled in the art without departing from the spirit and scope of the invention.

## Claims

1. An article of manufacture comprising an electronic device and a dielectric material in contact with the electronic device, the dielectric material comprising a silicone-polyimide co-polymer, characterized in that:
the dielectric material contains 0.2 to 1.6 percent by weight of a silane coupling agent selected from the group consisting of N-(2-aminoethyl-3-aminopropyl) trimethoxysilane and 3-mercaptopropyltrimethoxysilane.

2. The article of claim 1 further characterized in that:
the dielectric material constitutes a dielectric layer for separating the electronic device from a ceramic substrate, the ceramic substrate including conductors on one surface thereof.

3. The article of claim 2 further characterized in that:

the electronic device is a semiconductor chip and the dielectric material adheres both to the ceramic surface and to the conductors of the ceramic substrate.

4. The article of claim 3 further characterized in that:

the silicone-polyimide co-polymer is of the type which after cure has the formula

5. A process for making an electronic device comprising the steps of:

forming conductors on a surface; making a silicone-polyimide co-polymer precursor; depositing the precursor over the conductors; and curing the precursor by heating it to form a silicone-polyimide co-polymer, characterized in that:

prior to the depositing step, the precursor is mixed with a silane coupling agent selected from the group consisting of N-(2-aminoethyl-3-aminopropyl) trimethoxysilane and 3-mercaptopropyltrimethoxysilane such mixing resulting in a precursor containing 0.2 to 1.6 percent by weight of the silane coupling agent.

6. The method of claim 5 further characterized in that:

the curing step comprises the step of heating the precursor to 100°C for about one hour then at about 200°C for a period of about two hours.

7. The method of claim 5 further characterized in that:

the depositing step comprises screen printing the precursor.

8. The method of claim 7 further characterized in that:

after screen printing, a silicon chip is bonded to said surface.

9. The method of claim 5 further characterized in that:

the precursor prior to mixing with the silane coupling agent has the formula

10. The method of claim 9 further characterized in that:

the curing step comprises the step of heating the precursor at a temperature of 100°C to 200°C for between two and five hours.

11. The method of claim 10 further characterized in that:

the precursor contains at least 0.8 percent by weight of the silane coupling agent.

**FIG. 1**

10    12

17  15                                    15  17

14      15      17      15      14

11

## FIG. 2

(BPDA)    +    (MDA) (70%)

1)NMP
2)GAPD
19~

$NH_2$-$(CH_2)_3$-Si$\left(\begin{array}{c} CH_3 \\ | \\ | \\ CH_3 \end{array}\right)_2$O    (GAPTMDS)

(30%)

A-B-A TYPE (ACID AMIDE)

18~

EP 0 430 476 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | EP-A-0 184 937 (HITACHI) <br> * page 14, line 7 - page 16, line 16; claims 1, 3, 7 * <br> — — — | 1,5,6,10, 11,2,3 | H <br> 01 L 21/312 <br> H 01 L 23/498 |
| P,Y | US-A-4 897 153 (GENERAL ELECTRIC CY) <br> * column 3, lines 28 - 31; figure 1 * <br> — — — | 2,3 | |
| A | PROCEEDINGS OF THE 39TH ELECTRONIC COMPO- NENTS CO NFERENCE MAY 22-24,1989 IEEE IEEE NEW- YORK pages 148 - 154; A.W. LIN: "EVALUATION OF POLYIMIDES AS DIELECTRIC MATERIALS FOR MULTI- CHIP PACKAGES WITH MULTILEVEL INTERCONNEC- TION STRUCTURE" <br> * page 152, right-hand column, paragraph 1 * * page 153, right-hand column, paragraphs 1 - 3; figures 4, 8 * <br> — — — | 1,6 | |
| A | PATENT ABSTRACTS OF JAPAN vol. 7, no. 267 (E-213)(1412) 29 November 1983, <br> & JP-A-58 148441 (NITTO DENKI KOGYO) 03 September 1983, <br> * the whole document * | 1-6 | |

|  | TECHNICAL FIELDS SEARCHED (Int. Cl.5) |
|---|---|
|  | H 01 L |

The present search report has been drawn up for all claims

| Place of search | Date of completion of search | Examiner |
|---|---|---|
| The Hague | 08 March 91 | VANCRAEYNEST F.H. |